# DEMANDE DE BREVET EUROPEEN

(11) **EP 3 483 787 A1**
(43) Date de publication de la demande: **15.05.2019**
(21) Numéro de dépôt: 18205671.3
(22) Date de dépôt: 12.11.2018
(51) Int. Cl.: G06K 9/00, G01J 5/20, G01J 5/34

(54) **PROCÉDÉ DE RÉALISATION D'UN EMPILEMENT DE COUCHES POUR UN CAPTEUR THERMIQUE MATRICIEL**

(30) Priorité: 13.11.2017 FR 1760652
(71) Demandeur: Commissariat à l'énergie atomique et aux énergies alternatives, 75015 Paris (FR); Idemia Identity & Security France, 92130 Issy-les-Moulineaux (FR)
(72) Inventeur: REVAUX, Amélie, 38500 VOIRON (FR); FOURRE, Joël Yann, 92445 ISSY-LES-MOULINEAUX (FR); MAINGUET, Jean-François, 38100 GRENOBLE (FR)
(74) Mandataire: Brevalex

(57) **Abrégé**

L'invention concerne un procédé de réalisation d'une matrice de pixels d'un capteur thermique, adapté à un adressage passif. La matrice de pixels comporte :
- une couche comprenant une première série de bandes électriquement conductrices, formant des macro-électrodes de collecte de charges ;
- une couche comprenant un matériau pyroélectrique ; et
- une couche comprenant une seconde série de bandes électriquement conductrices, formant des bandes de chauffage.

Le procédé selon l'invention comprend une étape de report l'un sur l'autre d'un premier et second empilements élémentaires (302A, 302B), le premier empilement élémentaire (302A) comprenant la première série de bandes, et le second empilement élémentaire (302B) comprenant la seconde série de bandes.

L'invention permet de relâcher des contraintes de fabrication des séries de bandes.

## Description

### DOMAINE TECHNIQUE

L'invention se rapporte à un procédé pour réaliser une matrice de pixels d'un capteur thermique de type capteur pyroélectrique, adapté à la mise en oeuvre d'un adressage passif des pixels.

Un tel capteur forme par exemple un capteur d'empreinte papillaire, notamment un capteur d'empreinte digitale.

### ÉTAT DE LA TECHNIQUE ANTÉRIEURE

Un capteur pyroélectrique exploite les propriétés de pyroélectricité d'un matériau, c'est-à-dire sa capacité à générer des charges électriques en réponse à une variation de température.

Un tel capteur comporte une matrice de capacités pyroélectriques, formant chacune un transducteur pour traduire une variation temporelle de température en un signal électrique.

Chaque capacité pyroélectrique comporte une portion en matériau pyroélectrique, disposée entre une électrode inférieure et une électrode supérieure. L'une des électrodes est mise à un potentiel constant, et forme une électrode de référence. L'autre électrode, nommée électrode de collecte de charges, collecte des charges pyroélectriques générées par le matériau pyroélectrique en réponse à une variation de température. L'électrode de collecte de charges est connectée à un circuit de lecture, pour mesurer la quantité de charges collectée.

En fonctionnement, un objet est appuyé contre une surface de contact du capteur.

La détection peut exploiter simplement une différence de température entre cet objet et ladite surface de contact. Le capteur réalise alors une détection de type passif.

Dans le cas d'une détection d'empreinte digitale, le doigt est appuyé contre la surface de contact.

Au niveau des crêtes de l'empreinte, le doigt est en contact physique direct avec le capteur. Un transfert thermique entre la peau et la surface de contact du capteur s'effectue par conduction, ce qui conduit à une première variation temporelle de température.

Au niveau des vallées de l'empreinte, le doigt n'est pas en contact physique direct avec le capteur. Un transfert thermique entre la peau et la surface de contact du capteur s'effectue à travers l'air. L'air présente des propriétés d'isolant thermique, ce qui conduit à une seconde variation temporelle de température, moins importante.

La différence entre ces deux variations temporelles de température se traduit par une différence entre les signaux mesurés par les capacités pyroélectriques, selon qu'elles se trouvent sous une vallée ou sous une crête de l'empreinte. L'image de l'empreinte présente alors un contraste qui dépend de cette différence.

Après quelques secondes, la température du doigt et la température de la surface de contact s'homogénéisent, et il n'est plus possible d'obtenir un contraste satisfaisant.

Pour pallier à cet inconvénient, on ajoute des moyens de chauffage sous la surface de contact, pour dissiper une certaine quantité de chaleur dans chaque pixel du capteur. La variation de température mesurée dans chaque pixel du capteur se rapporte alors à la mesure dans laquelle cette quantité de chaleur est évacuée du pixel. Cela permet d'améliorer et de conserver au cours du temps, le contraste d'une image acquise à l'aide dudit capteur. Le capteur réalise alors une détection de type actif.

Dans le cas d'une détection d'empreinte digitale, la variation de température est importante au niveau des vallées de l'empreinte, où la chaleur n'est transférée au doigt qu'à travers l'air, et plus faible au niveau des crêtes de l'empreinte, où la chaleur est transférée efficacement au doigt, par conduction.

Dans un capteur thermique matriciel de type pyroélectrique, l'ajout des moyens de chauffage peut être mis à profit pour réaliser un adressage passif des pixels du capteur.

Chaque pixel comporte une capacité pyroélectrique, et un élément de chauffage.

Les pixels sont disposés selon des lignes et des colonnes. Les termes « ligne » et « colonne » peuvent être échangés, ce qui correspondrait à une simple rotation à 90° du capteur.

Les éléments de chauffage d'une même ligne de pixels sont reliés électriquement entre eux pour former une bande de chauffage. Chaque bande de chauffage est configurée pour pouvoir être activée indépendamment des autres bandes de chauffage. En d'autres termes, les éléments de chauffage des pixels d'une même ligne de pixels sont aptes à chauffer les portions en matériau pyroélectrique des pixels de ladite ligne, indépendamment des éléments de chauffage des pixels des autres lignes.

En outre, les électrodes de collecte de charges d'une même colonne de pixels sont reliées électriquement entre elles pour former une macro-électrode de collecte de charges. Chaque macro-électrode de collecte de charges est formée par une bande électriquement conductrice, en contact avec les portions en matériau pyroélectrique des pixels de ladite colonne de pixels, et distincte des bandes électriquement conductrices formant les macro-électrodes de collecte de charges des autres colonnes de pixels.

Chaque macro-électrode de collecte de charges permet de mesurer la somme des charges pyroélectriques, générées dans une même colonne de pixels.

Si l'on n'active à chaque instant qu'une seule des bandes de chauffage, dans chaque colonne de pixels il n'y a qu'un seul pixel qui génère des charges pyroélectriques. Les charges pyroélectriques collectées par la macro-électrode de collecte de charges se rapportent alors à cet unique pixel.

On réalise ainsi un adressage passif des pixels du capteur, sans transistor de sélection au sein de la matrice de pixels.

Un tel capteur est décrit dans la demande de brevet français n° 16 57391, déposée le 27 juillet 2016.

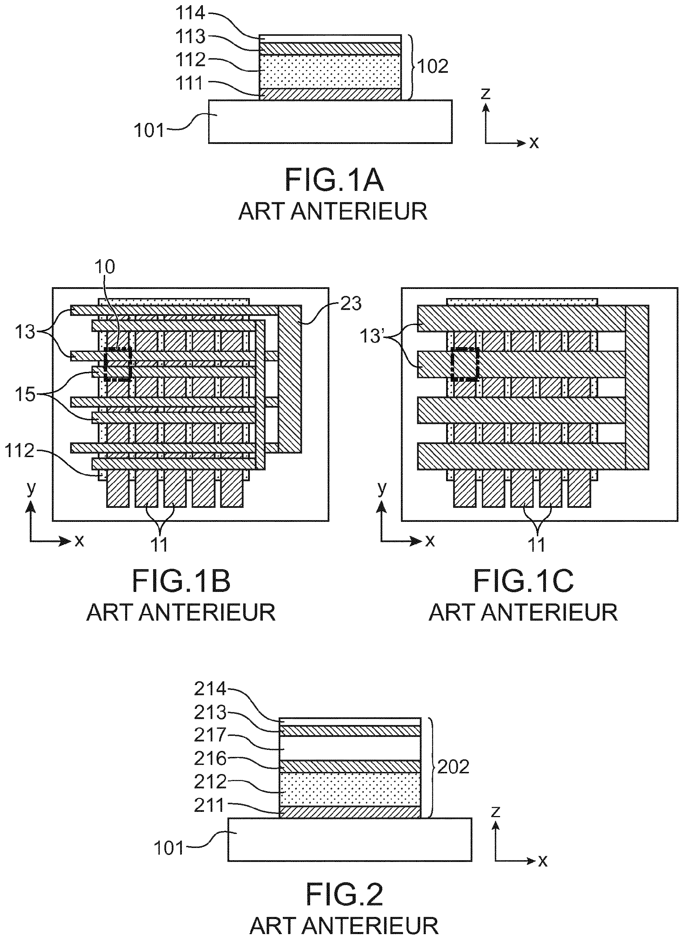

Les figures 1A et 1B représentent de façon schématique un premier mode de réalisation d'un empilement de couches, 102, formant la matrice de pixels d'un tel capteur.

Pour plus de clarté, on a représenté sur les figures les axes (Ox), (Oy) et/ou (Oz) d'un repère orthonormé.

A la figure 1A, l'empilement 102 est représenté selon une vue en coupe, dans un plan parallèle au plan (xOz).

A la figure 1B, l'empilement 102 est représenté selon une vue de dessus, dans un plan parallèle au plan (xOy).

L'empilement 102 s'étend sur un support mécanique 101.

Le support 101 est délimité verticalement par deux plans parallèles entre eux, parallèles au plan (xOy). Le plan du support désigne un plan parallèle à une face supérieure de celui-ci, parallèle au plan (xOy).

L'empilement 102 comprend, superposées les unes au-dessus des autres, dans cet ordre, et selon un axe (Oz) orthogonal au plan du support :
- une couche 111 d'électrodes de collecte de charges, comprenant une première série de bandes 11 électriquement conductrices, parallèles entre elles, formant les macro-électrodes de collecte de charges ;
- une couche 112 comprenant un matériau pyroélectrique ;
- une couche 113 de chauffage, comprenant une seconde série de bandes 13 électriquement conductrices, parallèles entre elles, formant les bandes de chauffage pour fournir un chauffage par effet Joule; et
- une couche de protection 114, optionnelle.

Dans l'exemple représenté en figures 1A et 1B, la couche de chauffage 113 comprend également une troisième série de bandes 15, électriquement conductrices, parallèles aux bandes de chauffage 13, et formant des macro-électrodes de référence communes à tous les pixels d'une même ligne de pixels.

Les bandes de chauffage 13 s'étendent ici selon l'axe (Ox).

Les macro-électrodes de collecte de charges 11 s'étendent selon l'axe (Oy).

Chaque pixel 10 s'étend, dans l'empilement 102, dans une région située à l'intersection entre une macro-électrode de collecte de charges 11, et un couple d'une macro-électrode de référence 15 et une bande de chauffage 13 voisines.

Les bandes de chauffage 13 présentent chacune une première extrémité, adaptée à être connectée à un potentiel électrique non nul, et une seconde extrémité, reliée de préférence à la masse. Ici, les secondes extrémités de toutes les bandes de chauffage sont reliées entre elles par l'intermédiaire d'une portion conductrice 23.

De la même façon, les macro-électrodes de référence 15 présentent chacune une première extrémité, adaptée à être connectée à un potentiel électrique fixe, et une seconde extrémité, reliée de préférence à la masse.

A la figure 1C, on a représenté une variante, dans laquelle les fonctions d'électrode de référence et de chauffage sont assurées par une même bande électriquement conductrice, 13'. Les bandes électriquement conductrices 13' présentent chacune une première extrémité, adaptée à être connectée à un potentiel électrique fixe et non nul, et une seconde extrémité, reliée de préférence à la masse.

La figure 2 illustre un deuxième mode de réalisation d'un empilement de couches, 202, formant la matrice de pixels d'un tel capteur.

L'empilement 202 comprend, superposées les unes au-dessus des autres, dans cet ordre, et selon un axe (Oz) orthogonal au plan du support :
- une couche 211 d'électrodes de collecte de charges, comprenant les macro-électrodes de collecte de charges telles que décrites ci-dessus ;
- une couche 212 comprenant un matériau pyroélectrique ;
- une couche 216 de blindage électromagnétique, électriquement conductrice ;
- une couche 217 d'isolation électrique, en matériau diélectrique ;
- une couche 213 de chauffage, comprenant les bandes de chauffage telles que décrites ci-dessus ; et
- une couche de protection 214, optionnelle.

La couche 216 de blindage électromagnétique est adaptée à être connectée à un potentiel constant, notamment à la masse. Elle offre une protection à l'égard des parasites électrostatiques, notamment autour de 50Hz, apportés par exemple par le contact avec la peau lorsque le doigt touche la surface de contact du capteur. Elle forme également une électrode de référence commune à tous les pixels de la matrice de pixels.

La couche 216 s'étend d'un seul tenant et de préférence sans ouverture, sur toute l'étendue de la matrice de pixels, dans un plan (xOy). Elle forme également une électrode de référence commune pour tous les pixels de la matrice de pixels.

L'objectif de l'invention est de proposer un procédé avantageux pour réaliser une matrice de pixels pour un capteur thermique à adressage passif de type capteur pyroélectrique, tel que décrit en référence aux figures 1A à 1C, et 2.

### EXPOSÉ DE L'INVENTION

Cet objectif est atteint avec un procédé de réalisation d'une matrice de pixels pour un capteur thermique, chaque pixel comprenant une capacité pyroélectrique formée par une portion comprenant un matériau pyroélectrique disposée entre une électrode de collecte de charge et une électrode de référence, et un élément de chauffage, les éléments de chauffage des pixels d'une même ligne de pixels étant formés ensemble d'un seul tenant en une même bande de chauffage, les électrodes de collecte de charge des pixels d'une même colonne de pixels étant formées ensemble d'un seul tenant en une même macro-électrode de collecte de charges, et la matrice de pixels étant constituée d'un empilement de couches comportant :
- une couche d'électrodes de collecte de charges, comprenant une première série de bandes électriquement conductrices parallèles entre elles, formant les macro-électrodes de collecte de charges ;
- une couche comprenant un matériau pyroélectrique comportant les portions en matériau pyroélectrique de chacun des pixels ; et
- une couche de chauffage, comprenant une seconde série de bandes électriquement conductrices parallèles entre elles, formant les bandes de chauffage.

Selon l'invention, le procédé comprend une étape de report l'un sur l'autre d'un premier et second empilements élémentaires, pour former ledit empilement de couches. Le premier empilement élémentaire comprend la couche d'électrodes de collecte de charges, et le second empilement élémentaire comprend la couche de chauffage. En d'autres termes, on reporte le premier empilement élémentaire sur le second, ou inversement, pour former la matrice de pixels d'un capteur thermique pyroélectrique à adressage passif.

En pratique, chaque pixel comprend une capacité pyroélectrique, c'est-à-dire une portion en matériau pyroélectrique, une électrode de collecte de charge, et une électrode de référence. Le cas échéant, un même élément forme à la fois l'électrode de référence et l'élément de chauffage du pixel (voir figure 1C ci-avant).

Dans l'empilement, la couche comprenant un matériau pyroélectrique est située entre la couche d'électrodes de collecte de charges, et la couche de chauffage. La couche comprenant un matériau pyroélectrique n'est pas nécessairement en contact physique direct avec la couche d'électrodes de collecte de charges et/ou avec la couche de chauffage. Une ou plusieurs couches supplémentaires peuvent être intercalées entre la couche comprenant un matériau pyroélectrique et la couche d'électrodes de collecte de charges, et/ou entre la couche comprenant un matériau pyroélectrique et la couche de chauffage.

Chaque pixel de la matrice de pixels est donc situé, dans l'empilement de couches, dans une région à l'intersection entre une bande de la première série de bandes et une bande de la seconde série de bandes. Pour cela, les bandes de la première et de la seconde séries de bandes ne sont pas parallèles entre elles.

Dans tout le texte, le terme « bande » n'est pas limité à une forme mince, de grande longueur et de largeur constante. Ce terme peut désigner n'importe quelle forme mince, plus longue que large. La largeur n'est pas forcément constante le long de l'axe d'allongement de la bande. Par exemple, une bande de chauffage peut être constituée d'une succession de portions étroites et larges, où des portions étroites sont centrées chacune sur un pixel du capteur et des portions larges sont disposées chacune à cheval entre deux pixels voisins.

On comprend que les portions comprenant un matériau pyroélectrique, associées chacune à l'un des pixels de la matrice de pixels, s'étendent dans la couche comprenant un matériau pyroélectrique.

Pour les raisons exposées ci-avant, la matrice de pixels est adaptée à la mise en oeuvre d'un adressage passif.

Une solution évidente pour réaliser l'empilement de couches selon l'invention, consiste à déposer successivement, les unes au-dessus des autres, chacune des couches constitutives de l'empilement.

On propose ici d'utiliser plutôt deux empilements distincts, reportés l'un sur l'autre pour former l'empilement complet, c'est-à-dire la matrice de pixels du capteur.

Ainsi, les bandes de chauffage ne sont pas réalisées au-dessus de la couche comprenant un matériau pyroélectrique.

On s'affranchit ainsi de la nécessité d'une compatibilité entre des étapes de réalisation des bandes de chauffage, et le matériau pyroélectrique.

Par exemple, lorsque la réalisation des bandes de chauffage implique l'utilisation d'un ou plusieurs solvant(s), il n'est plus nécessaire que ces solvants soient compatibles avec le matériau pyroélectrique.

De la même façon, lorsque les bandes de chauffage sont réalisées par dépôt d'une encre métallique, il n'est plus nécessaire que cette encre soit compatible avec le matériau pyroélectrique.

Les contraintes sur la réalisation des bandes de chauffage sont donc relâchées. En d'autres termes, l'invention donne accès à une plus large gamme de matériaux et procédés, pour réaliser les bandes de chauffage. Cela permet, notamment, de réaliser les bandes de chauffage selon un pas de répartition plus fin que dans l'art antérieur. On peut ainsi obtenir un capteur présentant une résolution améliorée.

En outre, l'invention permet que les bandes de chauffage soient réalisées sur une surface présentant une rugosité moindre, en comparaison avec la surface supérieure d'une couche en matériau pyroélectrique. On peut ainsi maîtriser plus facilement, et/ou avec plus de précision, la géométrie des bandes de chauffage, ainsi que leur pas de répartition.

Pour exemple, le poly(fluorure de vinylidène) (PVDF) et ses dérivés (notamment le copolymère PVDF-TrFE, TrFE pour Tri-fluoro-éthylène), communément utilisés pour réaliser la couche comprenant un matériau pyroélectrique, présentent une rugosité de surface importante (plusieurs centaines de nanomètres). On trouve donc facilement des supports de rugosité moindre, sur lesquels on réalise les bandes de chauffage.

On remarque également que dans le procédé selon l'invention, les bandes de chauffage ne sont pas réalisées au-dessus des macro-électrodes de collecte de charges. On s'affranchit ainsi d'éventuels défauts de planéité sur la surface recevant les bandes de chauffage, liés à la présence des macro-électrodes de collecte de charges en-dessous.

Lorsque les électrodes de collecte de charge sont distinctes les unes des autres, la matrice de pixels comporte des transistors de pilotage de ces électrodes, répartis en lignes et en colonnes. Chaque bande de chauffage doit alors s'étendre exactement au-dessus ou à proximité d'une ligne de commande d'une ligne de transistors.

Ici, les électrodes de collecte de charges d'une même colonne de pixels sont formées ensemble d'un seul tenant, en une macro-électrode de collecte de charges. On s'affranchit ainsi des transistors de pilotage répartis en lignes et colonnes dans la matrice de pixels. Cela permet de lever la contrainte relative à l'alignement précis d'une bande de chauffage par rapport à une ligne de commande d'une ligne de transistors. Par conséquent, dans le procédé selon l'invention, l'étape de report ne requiert pas une grande précision d'orientation relative des deux empilements élémentaires. En particulier, il n'est pas nécessaire que les bandes chauffantes soient orientées exactement à 90° relativement aux macro-électrodes de collecte de charges.

Selon un mode de réalisation avantageux, les premier et second empilements élémentaires sont configurés pour que, après l'étape de report, l'empilement de couches comprenne, superposées les unes au-dessus des autres dans cet ordre :
- la couche d'électrodes de collecte de charges ;
- la couche comprenant un matériau pyroélectrique ;
- une couche de blindage électromagnétique, électriquement conductrice ;
- une couche d'isolation électrique ; et
- la couche de chauffage.

La couche de blindage électromagnétique forme alors en outre les électrodes de référence des pixels de la matrice de pixels.

Selon une première variante de ce mode de réalisation avantageux :
- l'un au moins parmi les premier et second empilements élémentaires comprend une couche externe comprenant une colle électriquement isolante ; et
- dans l'empilement de couches, la colle se trouve entre la couche de chauffage et la couche de blindage électromagnétique, et forme la couche d'isolation électrique.

Selon une deuxième variante de ce mode de réalisation avantageux :
- l'un au moins parmi les premier et second empilements élémentaires comprend une couche externe comprenant une colle électriquement conductrice ; et
- dans l'empilement de couches, la colle se trouve entre la couche d'isolation électrique et la couche comprenant un matériau pyroélectrique, et forme la couche de blindage électromagnétique.

De préférence, l'un au moins parmi le premier et le second empilements élémentaires comprend une couche externe comportant une colle, et l'étape de report est suivie d'une étape de réticulation de la colle pour solidariser ensemble les premier et second empilements.

L'étape de report est avantageusement réalisée par pliage d'un unique substrat, le premier empilement élémentaire s'étendant sur une première région de l'unique substrat, et le second empilement élémentaire s'étendant sur une seconde région de l'unique substrat.

Un circuit intégré et des lignes électriquement conductrices peuvent être situés sur l'unique substrat, les lignes électriquement conductrices s'étendant chacune entre le circuit intégré et une extrémité d'une bande de la première série de bandes, respectivement de la seconde série de bandes.

La forme de l'unique substrat est avantageusement adaptée pour qu'à l'issue du pliage, au moins une extrémité de chaque bande de la première série de bandes ne soit pas recouverte par la seconde région de l'unique substrat, et au moins une extrémité de chaque bande de la seconde série de bandes ne soit pas recouverte par la première région de l'unique substrat.

En variante, l'étape de report est réalisée par report l'un au-dessus de l'autre d'un premier substrat et d'un second substrat distinct du premier substrat, le premier empilement élémentaire s'étendant sur le premier substrat, et le second empilement élémentaire s'étendant sur le second substrat.

Le second substrat peut être conservé à l'issue de l'étape de report, et former une couche de protection dans le capteur thermique.

En variante, le second substrat peut être retiré après l'étape de report.

Le procédé selon l'invention peut comprendre une étape de réalisation de la première série de bandes et de la seconde série de bandes, par dépôt d'une encre métallique.

L'invention concerne également un système adapté à la mise en oeuvre du procédé par pliage d'un unique substrat, le système comprenant le premier empilement élémentaire, le second empilement élémentaire et l'unique substrat, le premier empilement élémentaire s'étendant sur une première région de l'unique substrat, et le second empilement élémentaire s'étendant sur une seconde région de l'unique substrat.

Un circuit intégré et des lignes électriquement conductrices peuvent être situés sur l'unique substrat, les lignes électriquement conductrices s'étendant chacune entre le circuit intégré et une extrémité d'une bande de la première série de bandes, respectivement de la seconde série de bandes.

La forme de l'unique substrat est avantageusement adaptée pour qu'à l'issue du pliage, au moins une extrémité de chaque bande de la première série de bandes ne soit pas recouverte par la seconde région de l'unique substrat, et au moins une extrémité de chaque bande de la seconde série de bandes ne soit pas recouverte par la première région de l'unique substrat.

L'invention concerne enfin un système adapté à la mise en oeuvre du procédé par report l'un au-dessus de l'autre d'un premier substrat et d'un second substrat distinct du premier substrat, le système comprenant le premier empilement élémentaire, le second empilement élémentaire, un premier substrat, et un second substrat distinct du premier substrat, le premier empilement élémentaire s'étendant sur le premier substrat, et le second empilement élémentaire s'étendant sur le second substrat.

### BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :
- les figures 1A à 1C illustrent de manière schématique deux variantes d'un premier mode de réalisation d'une matrice de pixels pouvant être réalisée grâce au procédé selon l'invention ;
- la figure 2A illustre de manière schématique un deuxième mode de réalisation d'une matrice de pixels pouvant être réalisée grâce au procédé selon l'invention ;
- les figures 3A à 3C, et 4 illustrent de manière schématique un premier mode de réalisation d'un procédé selon l'invention ;
- les figures 5 et 6 illustrent différentes variantes de ce premier mode de réalisation ;
- les figures 7A et 7B illustrent de manière schématique un deuxième mode de réalisation d'un procédé selon l'invention ; et
- la figure 8 illustre une variante de ce deuxième mode de réalisation.

### EXPOSÉ DÉTAILLÉ DE MODES DE RÉALISATION PARTICULIERS

Dans la suite, mais de manière non limitative, on décrit des exemples de procédés pour réaliser un empilement du type de celui décrit en référence à la figure 2, cet empilement formant une matrice de pixels.

On décrit dans la suite des procédés de réalisation des premier et second empilements élémentaires 302A, 302B. Pour autant, le procédé selon l'invention ne comprend pas nécessairement la mise en oeuvre de ces étapes.

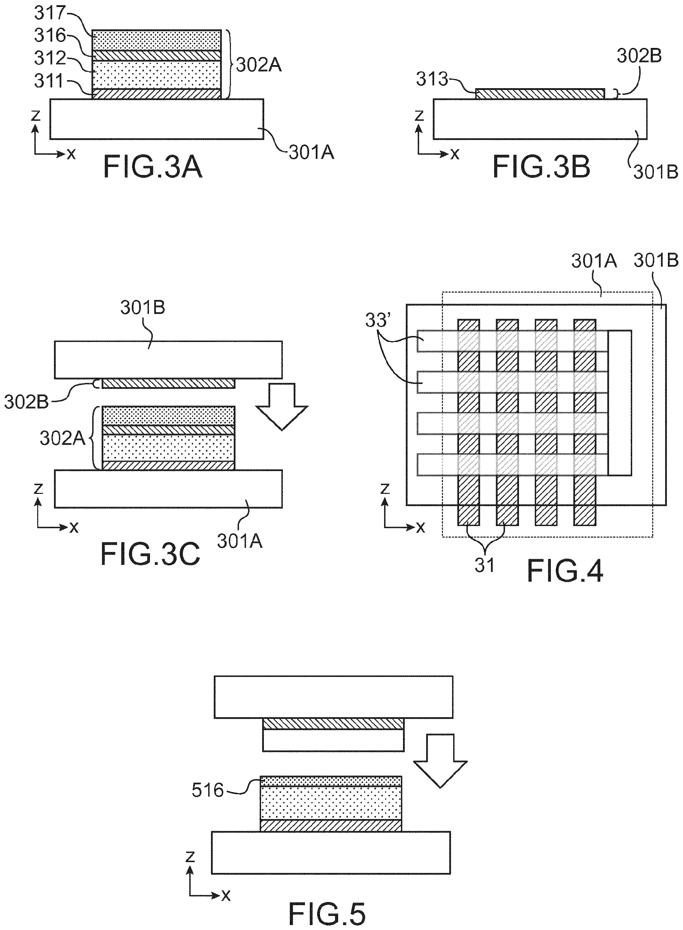

Le procédé selon l'invention utilise un premier empilement élémentaire, 302A (figure 3A), et un second empilement élémentaire, 302B (figure 3B).

Le premier empilement élémentaire, 302A, s'étend ici sur un premier substrat, 301A.

Le premier substrat 301A est par exemple en verre, en silicium, en un plastique tel que le poly(téréphtalate d'éthylène) (PET), en poly(naphtalate d'éthylène) (PEN), en polyimide (film Kapton), etc.

Il s'agit par exemple d'un substrat souple.

Le premier empilement élémentaire 302A comporte une série de couches, superposées les unes au-dessus des autres selon l'axe (Oz), c'est-à-dire selon un axe orthogonal au plan du premier substrat 301A.

Le premier empilement élémentaire 302A comporte ici, superposées au-dessus du premier substrat 301A :
- une couche 311 d'électrodes de collecte de charges, telle que décrite en introduction, comprenant des bandes métalliques parallèles entre elles formant des macro-électrodes de collecte de charges ;
- une couche 312 comprenant un matériau pyroélectrique, par exemple du PVDF ou de l'AIN (nitrure d'aluminium), ou du PZT (Titano-Zirconate de Plomb), etc. ;
- une couche 316 de blindage électromagnétique, électriquement conductrice, formant également une électrode de référence commune à tous les pixels de la matrice de pixels ; et
- une couche de colle 317, de préférence électriquement non conductrice.

Les macro-électrodes de collecte de charge sont réparties selon un pas inférieur ou égal à 150 µm, préférentiellement inférieur ou égal à 100 µm, et plus préférentiellement encore selon un pas inférieur ou égal à 51 µm.

Ce pas est par exemple de 80 µm environ (soit une résolution de 320 dpi). Par exemple, la largeur (selon (Ox)) d'une macro-électrode est de 40 µm, et la largeur de l'interstice entre deux macro-électrodes voisines est de 40 µm.

En variante, ce pas est de 50,8 µm (soit une résolution de 500 dpi). Par exemple, la largeur d'une macro-électrode est de 25,4 µm, et la largeur de l'interstice entre deux macro-électrodes voisines est de 25,4 µm.

Avant la réalisation des macro-électrodes de collecte de charge, le premier substrat 301A subit une étape de nettoyage (éthanol ou acétone ou plasma, suivant le substrat).

Les macro-électrodes sont ensuite réalisées sur le premier substrat 301.

Différentes techniques de réalisation des macro-électrodes peuvent être mises en oeuvre :
- lithographie (procédés de lithographie du domaine des circuits imprimés),
- dépôt d'une pleine couche électriquement conductrice puis ablation laser (par exemple un dépôt sous vide de type dépôt physique en phase vapeur ou dépôt chimique en phase vapeur, ou un dépôt par pulvérisation cathodique, etc.),
- impression de type sérigraphie (avec utilisation d'un masque ou pochoir),
- impression de type héliogravure (technique dans laquelle une encre est transférée directement d'un cylindre gravé vers une surface finale, adaptée plus particulièrement à de faibles pas de répartition des bandes métalliques),
- impression de type « offset gravure » (technique dans laquelle une encre est transférée d'un cylindre gravé vers une surface finale, par l'intermédiaire d'au moins un cylindre intermédiaire, adaptée plus particulièrement à de faibles pas de répartitions des bandes métalliques), etc.
- impression de type jet d'encre, etc.

Lorsque les macro-électrodes sont réalisées par impression, une encre électriquement conductrice, par exemple une encre métallique, est déposée, séchée puis recuite. Le recuit est réalisé par exemple dans une étuve, à une température comprise de préférence entre 20°C et 200°C selon la nature du substrat et de l'encre.

Les macro-électrodes sont par exemple des bandes d'or de 30 nm d'épaisseur, déposées par pulvérisation cathodique sur un premier substrat 301A constitué d'un feuillet de PEN de 125 µm d'épaisseur.

En variante, les macro-électrodes sont des bandes d'argent de 1,5 µm d'épaisseur, imprimées par offset gravure sur un premier substrat 301A constitué d'un feuillet de PEN de 125 µm d'épaisseur.

La couche 312 comprenant un matériau pyroélectrique présente par exemple une épaisseur comprise entre 2 µm et 4 µm.

Elle est déposée par exemple par sérigraphie ou par enduction centrifuge (spin-coating, en anglais).

Le matériau pyroélectrique peut être dispersé ou dissout dans une encre, puis déposé par un procédé d'impression. Après avoir été déposée, l'encre est séchée puis recuite, par exemple dans une étuve.

On utilise par exemple une encre à base d'un copolymère PVDF-TrFE. La quantité relative de TrFE (trifluoroéthylène) par rapport au PVDF dans l'encre impacte le coefficient pyroélectrique et la température de Curie de l'encre (température au-delà de laquelle un matériau perd ses propriétés pyroélectriques). Selon le type de substrat utilisé (et donc les températures de recuit accessibles), différentes formulations et ratios de PVDF-TrFE peuvent être utilisés.

En variante, on utilise une encre à base de PZT ou BaTiO₃ (titanate de baryum).

L'invention n'est cependant pas limitée à une couche 312 réalisée à partir d'une encre.

La couche 316 de blindage électromagnétique est constituée d'un matériau électriquement conducteur, et de préférence mauvais conducteur thermique. La mauvaise conduction thermique permet de limiter les transferts thermiques dans la couche 316, d'un pixel à l'autre de la matrice de pixels. La couche 316 présente une épaisseur réduite, favorisant des transferts de chaleur dans le sens de l'épaisseur. Elle est constituée par exemple d'une couche de 0,5 µm d'épaisseur en PEDOT:PSS (mélange de poly(3,4-éthylènedioxythiophène) (PEDOT) et le poly(styrène sulfonate) de sodium (PSS)). Si le matériau de la couche 316 est davantage conducteur d'électricité, la couche 316 peut être moins épaisse. Si le matériau de la couche 316 est meilleur conducteur thermique, la couche 316 doit être moins épaisse.

La couche de colle 317 est électriquement isolante.

Il s'agit par exemple d'une colle de type époxy (polymère époxyde).

La couche 317 forme également la couche d'isolation électrique telle que décrite en introduction, ce qui permet de limiter l'épaisseur de la matrice de pixels, et ainsi d'atteindre de plus grandes résolutions d'image (voir ci-après).

L'épaisseur de la couche 317 est avantageusement inférieure à 5 µm, par exemple 1 µm.

Le second empilement élémentaire, 302B, s'étend ici sur un second substrat, 301B.

Le second substrat 301B peut être identique au premier substrat 301A. En variante, il peut présenter une épaisseur moindre, inférieure ou égale à 30 µm, par exemple 15 µm.

Le second empilement élémentaire 302B est constitué uniquement de la couche de chauffage 313, telle que décrite en introduction.

Les bandes de chauffage de la couche 313 sont réparties de préférence selon un pas de répartition identique au pas de répartition des macro-électrodes de collecte de charge.

En tout état de cause, les bandes de chauffage de la couche 313 sont réparties selon un pas inférieur ou égal à 150 µm, préférentiellement inférieur ou égal à 100 µm, et plus préférentiellement encore selon un pas inférieur ou égal à 51 µm.

Ce pas est par exemple de 80 µm environ. Par exemple, la largeur (selon (Oy)) d'une bande de chauffage est de 40 µm, et la largeur de l'interstice entre deux bandes de chauffage voisines est de 40 µm.

En variante, ce pas est de 50,8 µm. Par exemple, la largeur d'une bande de chauffage est de 25,4 µm, et la largeur de l'interstice entre deux bandes de chauffage voisines est de 25,4 µm.

En tout état de cause, ce pas est de préférence identique au pas de répartition des macro-électrodes de collecte de charges (pour avoir des pixels carrés).

Avant de réaliser les bandes de chauffage sur le second substrat 301B, ce dernier subit une étape de nettoyage (éthanol ou acétone ou plasma, suivant le substrat).

Les bandes de chauffage de la couche 313 sont réalisées ensuite par des procédés similaires à ceux pouvant être utilisés pour réaliser les macro-électrodes de collecte de charges.

Le cas échéant, les bandes de chauffage et les macro-électrodes de collecte de charges peuvent être réalisées conjointement, dans une même étape de fabrication.

Les bandes de chauffage sont par exemple des bandes d'or, de 30 nm d'épaisseur (selon (Oz)), déposées par pulvérisation cathodique sur un second substrat 301B constitué d'un feuillet de PEN de 125 µm d'épaisseur.

En variante, les bandes de chauffage sont des bandes d'argent de 1,5 µm d'épaisseur, imprimées par offset gravure sur un second substrat 301B constitué d'un feuillet de PEN de 125 µm d'épaisseur.

Les macro-électrodes de collecte de charge et les bandes de chauffage peuvent présenter les mêmes caractéristiques (matériau et dimensions), ce qui permet qu'elles soient réalisées conjointement. Cependant, les macro-électrodes de collecte de charge supportent en pratique des courants moins importants que les bandes de chauffage, et peuvent, en variante, présenter des dimensions moindres, ou être constituées de matériaux conduisant moins bien l'électricité.

A la figure 3C, on a illustré l'étape de report, définissant le procédé selon l'invention.

Au cours de cette étape, l'ensemble constitué du second empilement élémentaire 302B et du second substrat 302B est retourné (rotation à 180°, autour de (Ox) ou (Oy)), puis déposé sur la couche de colle 317 du premier empilement 302A.

L'étape de report est suivie de préférence d'une étape de réticulation de la colle, pour solidariser ensemble le premier empilement 302A et le second empilement 302B. La réticulation de la colle peut être réalisée sous l'action de la chaleur, ou par irradiation par un faisceau à une longueur d'onde prédéterminée (par exemple infrarouge ou ultraviolet), ou par irradiation par un faisceau d'électrons.

Lors de l'étape de report, l'alignement latéral et angulaire du second empilement élémentaire 302B relativement au premier empilement élémentaire 302A n'est pas crucial. Cette liberté de positionnement est directement liée à la solution d'adressage passif des pixels, sans transistors entre les pixels de la matrice de pixels.

La figure 4 illustre de manière schématique, selon une vue de dessus, l'empilement total obtenu à l'issue de l'étape de report. Ici, les macro-électrodes de collecte de charges, 31, sont orientées à 90° relativement aux bandes de chauffage 33'.

Dans l'exemple illustré en figure 4, les dimensions du premier substrat 301A et du second substrat 302B sont adaptées pour que, après l'étape de report :
- chaque macro-électrode 31 présente une extrémité non recouverte par le second substrat 301B ; et
- chaque bande de chauffage 33' présente une extrémité non recouverte par le premier substrat 301A.

Cette configuration permet de faciliter l'accès aux bandes de chauffage et aux macro-électrodes, pour la connexion à des circuits de pilotage du chauffage, respectivement à des circuits de lecture.

Les circuits de lecture et de pilotage du chauffage sont par exemple réalisés sur un substrat distinct des premier et second substrats 301A, 301B. La connexion avec les macro-électrodes 31, respectivement les bandes de chauffage 33', est assurée par des connecteurs souples (flex).

En variante, les circuits de lecture et de pilotage du chauffage sont réalisés sur l'un des substrats 301A ou 301B, et un connecteur souple s'étend entre les deux substrats.

Selon une autre variante, chacun des substrats reçoit une partie des circuits de lecture et de pilotage du chauffage, et un connecteur souple s'étend entre les deux substrats.

L'idée à la base de l'invention réside dans l'étape de report décrite ci-dessus.

De manière optionnelle, le procédé selon l'invention peut comprendre les étapes de réalisation des premier et second empilements élémentaires 302A, 302B, sur le premier, respectivement le second, substrats 301A, 301B.

Le procédé selon l'invention peut également comprendre une étape de polarisation du matériau pyroélectrique de la couche 312. Il s'agit de soumettre la couche 312 à un champ électrique intense, pour modifier durablement l'orientation de ses molécules, et pour lui conférer ainsi des propriétés de pyroélectricité.

L'invention couvre également un système adapté à la mise en oeuvre de ce premier mode de réalisation d'un procédé selon l'invention. Le système comprend en particulier le premier empilement élémentaire 302A, le second empilement élémentaire 302B, le premier substrat 301A et le second substrat 301B.

Dans un capteur tel que décrit ici, la distance entre la surface de contact et une surface supérieure des macro-électrodes de collecte de charge, du côté de la surface de contact, définit une résolution maximale d'image (la chaleur se propageant verticalement dans la matrice de pixels, mais également horizontalement, d'un pixel à l'autre de la matrice de pixels).

De préférence, cette distance inférieure ou égale au pas de pixel du capteur.

Cette distance est donc avantageusement inférieure ou égale à 150 µm, et même inférieure ou égale à 50 µm voire 10 µm.

Lorsque l'on souhaite accéder à de faibles pas de pixels (par exemple lorsque le capteur est un capteur d'empreinte digitale), on a donc le choix entre manipuler un second substrat de faible épaisseur (par exemple moins de 15 µm), ou retirer le second substrat après l'étape de report (dans ce cas, une couche de protection peut être ajoutée au second empilement, sur le second substrat).

Lorsqu'une grande résolution n'est pas nécessaire (par exemple lorsque le capteur forme un simple détecteur de présence, pour détecter la présence ou l'absence d'un corps sur une surface, par exemple la présence ou l'absence d'une main sur une surface), le second substrat 301B peut à la fois présenter une grande épaisseur (plus de 100 µm), et être conservé après l'étape de report.

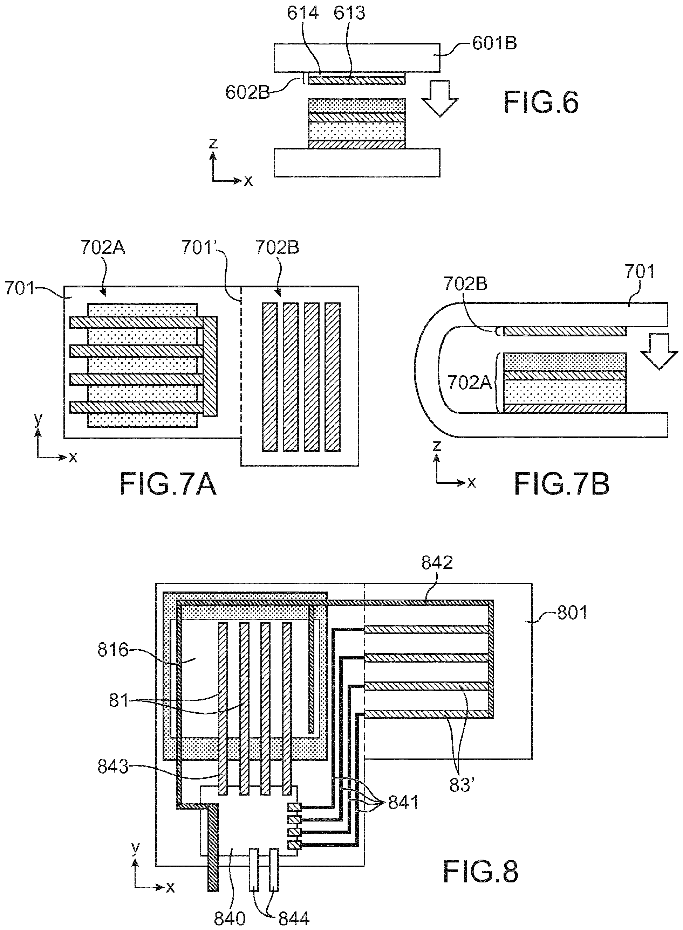

Les figures 5 et 6 illustrent différentes variantes du procédé décrit ci-avant.

A la figure 5, la couche de colle 516 est électriquement conductrice. Elle forme la couche supérieure du premier empilement élémentaire, et fait également office de couche de blindage électromagnétique.

Une colle électriquement conductrice est par exemple une colle de type époxy, chargée en particules métalliques, par exemple chargée en particules d'argent.

Cette variante permet que les premier et second empilements élémentaires comprennent chacun :
- une couche comprenant des bandes électriquement conductrices (selon l'empilement, la couche d'électrodes de collecte de charges, ou la couche de chauffage) ; et
- une couche comprenant un matériau apte à présenter des propriétés de pyroélectricité, selon qu'un a été soumis ou non à un champ de polarisation (selon l'empilement, la couche comprenant un matériau pyroélectrique, ou la couche d'isolation électrique).

Cette variante facilite une réalisation conjointe des premier et second empilements élémentaires. Elle est particulièrement adaptée lorsque le second substrat est conservé après l'étape de report.

De nombreuses autres variantes peuvent être mises en oeuvre, où la couche de colle forme la couche supérieure du premier empilement élémentaire, et/ou du second empilement élémentaire, du côté opposé au premier substrat, respectivement second substrat.

A la figure 6, le second substrat 601B forme un simple substrat de report, ou carrier, par exemple en verre, destiné à être séparé du second empilement élémentaire à l'issue de l'étape de report. Il confère au second empilement élémentaire 602B la stabilité mécanique nécessaire pour la mise en oeuvre de l'étape de report. Des traitements de surface, ou l'insertion d'une couche d'accroche intermédiaire adhésive, peuvent être mis en oeuvre sur le second substrat 601B, avant réalisation du second empilement élémentaire, pour faciliter un futur délaminage (délaminage réalisé, par exemple, avec un laser).

Ici, une fine couche de protection 614, est ajoutée au second empilement élémentaire 602B, entre le second substrat 601B et la couche de chauffage 613. La couche de protection 614 est par exemple une couche en DLC (Diamond Like Carbon), une résine anti-rayures, un substrat ultra-mince tel qu'un kapton ou un polyimide de 5 à 25 µm d'épaisseur, un substrat de verre mince, etc.

De préférence, la fine couche de protection 614 présente une épaisseur inférieure ou égale à 25 µm, voire inférieure ou égale à 10 µm, et même moins (par exemple une couche de DLC d'épaisseur inférieure ou égale à 1 µm ou une couche de résine anti-rayure déposée par spray ou par sérigraphie d'épaisseur 3µm).

Ce mode de réalisation permet de limiter une distance entre la surface de contact du capteur et les macro-électrodes de collecte de charge, et ainsi d'améliorer la résolution du capteur en limitant la diathermie (ou cross-talk, ou échanges de chaleur) entre pixels voisins.

Les figures 7A et 7B illustrent de manière schématique un deuxième mode de réalisation d'un procédé selon l'invention.

Selon ce mode de réalisation, le premier empilement élémentaire 702A et le second empilement élémentaire 702B s'étendent chacun sur deux régions d'un même substrat 701, et l'étape de report est mise en oeuvre par pliage de cet unique substrat 701, de sorte que ces deux régions se retrouvent l'une au-dessus de l'autre.

L'unique substrat 701 est ici un substrat souple, par exemple un substrat en polyimide de 5 µm à 10 µm d'épaisseur, ou en un plastique tel que le PET, voire même en verre.

A la figure 7A, on a représenté de façon schématique, selon une vue de dessus, le substrat 701 à l'état déplié, avec les deux empilements élémentaires 702A, 702B. La ligne de pliure 701' est représentée en pointillés.

Ici, la forme du substrat 701 est adaptée pour que les bandes de chauffage, respectivement les macro-électrodes de collecte de charges, présentent chacune une extrémité dite « libre », qui n'est pas encadrée selon l'axe (Oz) entre deux portions du substrat 701. Ces extrémités libres facilitent la connexion à des circuits, déportés, de lecture et de pilotage du chauffage.

A la figure 7B, on a représenté de façon schématique, selon une vue en coupe, le substrat 701 partiellement replié, avec les deux empilements élémentaires 702A, 702B.

Ce mode de réalisation permet notamment de faciliter la réalisation, dans une même étape de procédé, des bandes de chauffage et des macro-électrodes de collecte de charges.

L'invention couvre également un système adapté à la mise en oeuvre de ce deuxième mode de réalisation d'un procédé selon l'invention. Le système comprend en particulier le premier empilement élémentaire 702A, le second empilement élémentaire 702B, et l'unique substrat 701.

Les variantes décrites en référence aux figures 5 et 6 peuvent être adaptées à ce deuxième mode de réalisation. On peut notamment retirer, après le pliage, une région du substrat 701, formant initialement support pour le second empilement élémentaire.

Selon une autre variante, le substrat 701 peut présenter des régions de différentes épaisseurs, le premier empilement élémentaire 702A étant situé sur une région de grande épaisseur, et le second empilement élémentaire 702B étant situé sur une région de faible épaisseur.

La figure 8 illustre une variante avantageuse de ce deuxième mode de réalisation, dans laquelle un circuit intégré 840 est formé sur l'unique substrat 801.

Le circuit intégré comprend ici une puce en silicium, collée sur l'unique substrat 801.

Différentes pistes, ou lignes, électriquement conductrices s'étendent sur l'unique substrat, en particulier :
- des lignes de pilotage du chauffage, 841, s'étendant chacune entre le circuit intégré 840 et une première extrémité de chacune des bandes de chauffage 83' ;
- une ligne de masse, 842, passant par les secondes extrémités de chacune des bandes de chauffage 83', et par au moins un bord de la couche 816 de blindage électromagnétique ;
- des lignes d'électrodes, 843, s'étendant chacune entre le circuit intégré 840 et une première extrémité de chacune des macro-électrodes de collecte de charges 81 ; et
- des lignes de sortie, 844, pour la connexion électrique du circuit intégré 840 avec des éléments externes.

Dans ce mode de réalisation, les circuits de lecture et de pilotage du chauffage sont réalisés sur une même puce, ce qui simplifie une synchronisation du chauffage avec la lecture des quantités de charges pyroélectriques, et permet de limiter le nombre de lignes de sortie 844 à réaliser avec l'extérieur par multiplexage des données.

L'idée à la base de l'invention est donc de fabriquer la matrice de pixels en deux parties, assemblées de préférence avec de la colle. Ainsi, les impressions nécessitant de la précision ne subissent pas de perte de résolution liée à la planéité de couches inférieures, notamment la couche comportant un matériau pyroélectrique. Ces impressions ne sont pas non plus affectées par des problèmes d'adhérence et/ou de compatibilité avec des couches inférieures, notamment la couche comportant un matériau pyroélectrique. Ces impressions peuvent être faites chacune directement sur un substrat.

L'étape de report utilise deux substrats, ou deux portions d'un même substrat, recevant chacune une partie des couches formant la matrice de pixels du capteur.

En fonctionnement, un objet à imager ou à détecter est appuyé contre une surface de contact du capteur. Cette surface de contact peut être située sur l'un de ces deux substrats, ou l'une de ces deux portions de substrat.

Dans la description ci-dessus, on considère que c'est l'empilement élémentaire comportant les bandes de chauffage qui est retourné et déplacé. De manière équivalente, on peut choisir de retourner plutôt l'empilement élémentaire comportant les macro-électrodes de collecte de charge.

De la même façon, la couche de colle peut être déposée plutôt sur l'empilement élémentaire comportant les bandes de chauffage (voire sur les deux empilements élémentaires).

De nombreuses autres variantes du procédé selon l'invention peuvent être mises en oeuvre sans sortir du cadre de l'invention, par exemple avec différents empilements élémentaires. En particulier, le procédé selon l'invention peut également servir à réaliser un empilement tel que décrit en référence aux figures 1A à 1C.

On peut s'affranchir d'une couche de colle pour solidariser ensemble les premier et second empilements élémentaires. Par exemple, on peut réaliser deux empilements élémentaires comprenant chacun une couche supérieure en matériau pyroélectrique, puis réaliser un frittage pour solidariser ensemble ces deux couches en matériau pyroélectrique, après l'étape de report.

On peut réaliser un report dit collectif, pour réaliser simultanément plusieurs matrices de pixels, à partir d'un seul ou de deux substrats recevant une pluralité de premiers et seconds empilements élémentaires. Le ou les substrats peuvent présenter des ouvertures traversantes, pour faciliter l'accès de connecteurs électriques aux bandes de chauffage et/ou aux macro-électrodes de collecte de charges.

Le premier empilement élémentaire peut s'étendre initialement sur un substrat ultra-mince. Après l'étape de report, on peut coller l'ensemble obtenu sur un support plus rigide, par exemple sur une carte à puce.

On peut également utiliser le procédé selon l'invention pour réaliser un capteur thermique matriciel à adressage passif, dans lequel chaque pixel comporte deux cellules pyroélectriques superposées, l'une dédiée à la mesure d'un signal total, et l'autre à la mesure d'un signal de bruit.

Les positions des bandes de chauffage et des électrodes de collecte de charge peuvent être échangées. Elles ne sont pas nécessairement constituées d'une encre conductrice.

Dans les exemples représentés, on réalise directement des bandes de chauffage, respectivement des macro-électrodes de collecte de charge, indépendantes les unes des autres. En variante, elles peuvent être initialement reliées ensemble, pour faciliter une étape de polarisation de la couche comprenant un matériau pyroélectrique. Des portions conductrices les reliant ensemble sont supprimées après l'étape de report, lors d'une étape de découpe (par exemple pour séparer différentes matrices de pixels après un report collectif).

Bien que non représentés, le capteur comporte au moins un circuit de lecture, pour mesurer une quantité de charges collectée par une électrode de collecte de charges, et au moins un circuit de pilotage du chauffage, pour l'envoi de signaux électriques permettant de chauffer les pixels du capteur par l'intermédiaire des bandes de chauffage. Il peut comporter en outre un circuit électronique de traitement apte à construire une image globale d'un motif thermique, à partir de mesures réalisées au niveau de chacun des pixels du capteur.

Le motif thermique pouvant être imagé par le capteur peut être une empreinte papillaire, ou tout autre motif associé à un objet ayant une capacité thermique et une chaleur massique.

L'invention est particulièrement adaptée à la fabrication de capteurs de grandes dimensions (surface de la matrice de pixels supérieure à 1 cm²). De tels capteurs sont intégrés par exemple sur une carte à puce, un vêtement, ou un accessoire portatif.

## Revendications

1. Procédé de réalisation d'une matrice de pixels pour un capteur thermique, chaque pixel comprenant une capacité pyroélectrique formée par une portion comprenant un matériau pyroélectrique disposée entre une électrode de collecte de charge et une électrode de référence, et un élément de chauffage, les éléments de chauffage des pixels d'une même ligne de pixels étant formés ensemble d'un seul tenant en une même bande de chauffage (13 ; 13' ; 33' ; 83'), les électrodes de collecte de charge des pixels d'une même colonne de pixels étant formées ensemble d'un seul tenant en une même macro-électrode de collecte de charges (11; 31; 81), et la matrice de pixels étant constituée d'un empilement de couches (102 ; 202) comportant :
- une couche (111 ; 211 ; 311) d'électrodes de collecte de charges, comprenant une première série de bandes électriquement conductrices parallèles entre elles, formant les macro-électrodes de collecte de charges (11 ; 31 ; 81) ;
- une couche (112 ; 212 ; 312) comprenant un matériau pyroélectrique, comportant les portions en matériau pyroélectrique de chacun des pixels ; et
- une couche de chauffage (113 ; 213; 313 ; 613), comprenant une seconde série de bandes électriquement conductrices parallèles entre elles, formant les bandes de chauffage (13 ; 13' ; 33' ; 83'), avec la couche comprenant un matériau pyroélectrique située entre la couche d'électrodes de collecte de charges et la couche de chauffage ;
**caractérisé en ce qu'**il comprend une étape de report l'un sur l'autre d'un premier et d'un second empilements élémentaires (302A, 302B ; 402A ; 602B ; 702A, 702B), pour former ledit empilement de couches, le premier empilement élémentaire (302A; 402A; 702A) comprenant la couche (111 ; 211 ; 311) d'électrodes de collecte de charges, et le second empilement élémentaire (302B ; 602B ; 702B) comprenant la couche de chauffage (113 ; 213 ; 313 ; 613).

2. Procédé selon la revendication 1, **caractérisé en ce que** les premier et second empilements élémentaires (302A, 302B ; 402A; 602B ; 702A, 702B) sont configurés pour que, après l'étape de report, l'empilement de couches comprenne, superposées les unes au-dessus des autres dans cet ordre :
- la couche (311) d'électrodes de collecte de charges ;
- la couche (312) comprenant un matériau pyroélectrique ;
- une couche de blindage électromagnétique (316 ; 416; 816), électriquement conductrice ;
- une couche d'isolation électrique (317 ; 417) ; et
- la couche de chauffage (313 ; 613).

3. Procédé selon la revendication 2, **caractérisé en ce que** :
- l'un au moins parmi les premier et second empilements élémentaires comprend une couche externe comprenant une colle électriquement isolante ; et
- dans l'empilement de couches, la colle se trouve entre la couche de chauffage (313) et la couche de blindage électromagnétique (316), et forme la couche d'isolation électrique (317).

4. Procédé selon la revendication 2, **caractérisé en ce que** :
- l'un au moins parmi les premier et second empilements élémentaires comprend une couche externe comprenant une colle électriquement conductrice ; et
- dans l'empilement de couches, la colle se trouve entre la couche d'isolation électrique et la couche comprenant un matériau pyroélectrique, et forme la couche de blindage électromagnétique (516).

5. Procédé selon l'une quelconque des revendications 1 à 4, **caractérisé en ce que** l'un au moins parmi le premier et le second empilements élémentaires (302A, 302B ; 402A ; 602B ; 702A, 702B) comprend une couche externe (317 ; 418 ; 516) comportant une colle, et **en ce que** l'étape de report est suivie d'une étape de réticulation de la colle pour solidariser ensemble les premier et second empilements.

6. Procédé selon l'une quelconque des revendications 1 à 5, **caractérisé en ce que** l'étape de report est réalisée par pliage d'un unique substrat (701 ; 801), le premier empilement élémentaire (702A) s'étendant sur une première région de l'unique substrat, et le second empilement élémentaire (702B) s'étendant sur une seconde région de l'unique substrat.

7. Procédé selon la revendication 6, **caractérisé en ce qu'**un circuit intégré (840) et des lignes électriquement conductrices (841, 842, 843, 844) sont situés sur l'unique substrat (801), les lignes électriquement conductrices s'étendant chacune entre le circuit intégré (840) et une extrémité d'une bande de la première série de bandes (81), respectivement de la seconde série de bandes (83').

8. Procédé selon la revendication 6, **caractérisé en ce que** la forme de l'unique substrat (701) est adaptée pour qu'à l'issue du pliage, au moins une extrémité de chaque bande de la première série de bandes ne soit pas recouverte par la seconde région de l'unique substrat, et au moins une extrémité de chaque bande de la seconde série de bandes ne soit pas recouverte par la première région de l'unique substrat.

9. Procédé selon l'une quelconque des revendications 1 à 8, **caractérisé en ce que** l'étape de report est réalisée par report l'un au-dessus de l'autre d'un premier substrat (301A) et d'un second substrat (301B ; 601B) distinct du premier substrat, le premier empilement élémentaire (302A ; 402A) s'étendant sur le premier substrat, et le second empilement élémentaire (302B ; 602B) s'étendant sur le second substrat.

10. Procédé selon la revendication 9, **caractérisé en ce que** le second substrat (301B) est conservé à l'issue de l'étape de report, et forme une couche de protection dans le capteur thermique.

11. Procédé selon la revendication 9, **caractérisé en ce que** le second substrat (302B ; 602B) est retiré après l'étape de report.

12. Procédé selon l'une quelconque des revendications 1 à 11, **caractérisé en ce qu'**il comprend une étape de réalisation de la première série de bandes (11 ; 31; 81) et de la seconde série de bandes (13 ; 13' ; 33' ; 83'), par dépôt d'une encre métallique.

13. Système adapté à la mise en oeuvre du procédé selon l'une quelconque des revendications 6 à 8, **caractérisé en ce qu'**il comprend le premier empilement élémentaire (702A), le second empilement élémentaire (702B) et l'unique substrat (701; 801), le premier empilement élémentaire (702A) s'étendant sur une première région de l'unique substrat, et le second empilement élémentaire (702B) s'étendant sur une seconde région de l'unique substrat.

14. Système adapté à la mise en oeuvre du procédé selon l'une quelconque des revendications 9 à 11, **caractérisé en ce qu'**il comprend le premier empilement élémentaire (302A ; 402A), le second empilement élémentaire (302B ; 602B), un premier substrat (301A), et un second substrat (301B ; 601B) distinct du premier substrat, le premier empilement élémentaire (302A ; 402A) s'étendant sur le premier substrat, et le second empilement élémentaire (302B ; 602B) s'étendant sur le second substrat.
